(19) Europäisches Patentamt
European Patent Office
Office européen des brevets

(11) **EP 1 950 828 A1**

(12) **EUROPEAN PATENT APPLICATION**

(43) Date of publication:
**30.07.2008 Bulletin 2008/31**

(51) Int Cl.:
***H01P 1/213*** (2006.01)     ***H03H 7/46*** (2006.01)

(21) Application number: **07001610.0**

(22) Date of filing: **25.01.2007**

(84) Designated Contracting States:
**AT BE BG CH CY CZ DE DK EE ES FI FR GB GR HU IE IS IT LI LT LU LV MC NL PL PT RO SE SI SK TR**
Designated Extension States:
**AL BA HR MK RS**

(71) Applicants:
- **Mitsubishi Electric Information Technology Centre**
  **Europe B.V.**
  **1119 NS  Schiphol Rijk (NL)**
  Designated Contracting States:
  **FR**
- **MITSUBISHI ELECTRIC CORPORATION**
  **Chiyoda-ku**
  **Tokyo 100-8310 (JP)**
  Designated Contracting States:
  **AT BE BG CH CY CZ DE DK EE ES FI GB GR HU IE IS IT LI LT LU LV MC NL PL PT RO SE SI SK TR**

(72) Inventor: **Mallegol, Stéphane**
**35708 Rennes Cedex 7 (FR)**

(74) Representative: **Maillet, Alain**
**Cabinet Le Guen & Maillet**
**5, place Newquay**
**B.P. 70250**
**35802 Dinard Cedex (FR)**

(54) **Passive microwave (de)multiplexer**

(57)     The present invention relates to a microwave filter bank intended to be used either as or a multiplexer or de-multiplexer in a UWB-type system, said microwave filter bank including a plurality of filters and an interconnection network both connecting a first port (Pifb) of said microwave filter bank to other ports of said microwave filter bank. Said microwave filter bank is characterised in that said interconnection network includes a plurality of inductors, one of said inductors (Li), said first, has one of its extremities directly connected to said first port (Pifb) and its second extremity connected to the ground through a capacitor (Ci), said first, intended to minimize the effect of the reflection response of the microwave filter bank in its operating sub-bands without degrading its transmission response, said first inductor (Li) and capacitor (Ci) being intended to provide a nearly constant total admittance at said first port of said microwave filter bank for the operating band of each of said filters, each of other inductors, said second, is intended to provide a good in-band matching of the response of one of said filters with a targeted response.

Fig. 1

EP 1 950 828 A1

## Description

The present invention relates to microwave filter banks intended to dispatch electromagnetic energy from an input port toward a plurality of output ports depending on the frequency of the input signal and, conversely, to merge the electromagnetic energy from a plurality of output ports towards the input port. The invention also relates to a transceiver of the UWB (Ultra-Wide Band) type using such at least one microwave filter bank acting either as an energy splitter (de-multiplexer) or as an energy combiner (multiplexer).

Generally speaking, a microwave filter bank is a device which is intended to dispatch electromagnetic energy from an input port toward a plurality of output ports depending on the frequency of the input signal and, conversely, to merge the electromagnetic energy from a plurality of output ports towards the input port. For example, such a filter bank can be used either as an energy splitter when the signal in a frequency band propagates from the input port to the output ports where only sub-bands are delivered or as an energy combiner when signals in different sub-bands propagate from the output ports to the input port. Such filter banks are thus said reciprocal. Furthermore, when said signals carry information or are representative of data, the microwave filter banks of the invention can act either as multiplexers or as de-multiplexers depending on the propagation direction of the signals.

A microwave filter bank according to the type of the one of the present invention generally comprises an interconnection network and filters which are connected to the access points thereof. Different types of interconnection networks are well-known in the art. One is a directional coupler essentially constituted of two lines lying one parallel to the other at a low distance in order to be coupled. More than two lines that are two by two linked can be also coupled resulting in the so-called Lange configuration. Examples of embodiments of such interconnection networks can be seen in the patent document US-A-2004/0113716.

Another type of interconnection network can be seen in the Wilkinson power divider that is constituted of two quarter-wave line segments one extremity of each being connected to the input port of the network and the other to a respective output port, the two output ports being connected by a lumped resistor. Such a power divider is for example described in the patent document US-A-4 367 445.

Other types of interconnection networks are also well-known in the art but they are not described here. For example, a 1/N multiport power divider is described in the document authored by Masashi Nakatsugawa, entitled "A novel configuration for 1/N multiport power dividers using series/parallel transmission line division and a polyimidelalumina ceramic structure for HPA module implementation" and published in IEEE transactions on microwave theory and techniques, col 49, No 6, June 2001.

The drawback of the microwave filter banks using the known interconne*ction networks as those aforementioned is what is called the power division effect. Such an effect is an attenuation, often around 3dB for a two output ports interconnection network, which is due to the insertion of the interconnection network in the microwave filter bank. An attenuation always occurs in filter bank due to the filters themselves but this attenuation gets worse if the power effect division effect exists. An interconnecting network without any (or at least minimised) power division effect will have thus better energy performance.

The present invention aims at solving the aforementioned problem by providing an interconnection network that does not present the drawbacks mentioned above and that are therefore of such a structure that distributes equitably the input energy on each of their output ports by providing a nearly constant total input admittance at the input of the microwave filter bank over its operating frequency band when the microwave filter bank acts as a de-multiplexer. Furthermore, the present invention provides an original interconnection network including passive integrated inductors and capacitors, which does not require any energy supply for working. Such an interconnection network is also compatible with semiconductor technology and is thus more easily miniaturized than classic interconnection networks.

More precisely, the present invention concerns a microwave filter bank intended to be used either as or a multiplexer or de-multiplexer in a UWB-type system. Said microwave filter bank includes a plurality of filters and an interconnection network both connecting a first port of said microwave filter bank to other ports of said microwave filter bank. Said microwave filter bank is characterised in that said interconnection network includes a plurality of inductors, one of said inductors, said first, has one of its extremities directly connected to said first port and its second extremity connected to the ground through a capacitor, said first, intended to minimize the effect of the reflection response of the microwave filter bank in its operating sub-bands without degrading its transmission response, said first inductor and capacitor being intended to provide a nearly constant total admittance at said first port of said microwave filter bank for the operating band of each of said filters, each of other inductors, said second, is intended to provide a good in-band matching of the response of one of said filters with a targeted response.

Advantageously, an extremity of each of said second inductors is connected to the ground through a capacitor intended to balance the in-band reflection levels over the frequency response of said filters.

Advantageously, an extremity of each inductor is connected to a common point, said central feeding point, of the interconnection network, said central feeding point being connected to the ground through said first capacitor.

According to an embodiment, said extremity of each inductor is connected to said central feeding point through at least one transmission line.

According to a first embodiment of the present invention, each of said filters is connected to a single port of said microwave filter bank and to a single of said second inductors.

According to another embodiment of the present invention, said interconnection network includes at least one other of said first inductor connected each to a different central feeding point, at each of said central feeding point at least two of said second inductors are connected.

According to a material aspect of the invention, the present invention concerns also a transceiver intended to be used in a UWB-type system. Such a transceiver is characterised in that it includes at least one microwave filter bank according to one of previously embodiments, said at least one microwave filter bank being intended to be used either as an energy splitter of an electromagnetic energy signal or an energy combiner of multiple electromagnetic energy signals.

The characteristics of the invention mentioned above, as well as others, will emerge morc clearly from a reading of the following description given in relation to the accompanying figures, amongst which:

Fig. 1 which synoptically shows a microwave filter bank according to a first embodiment of the present invention,
Fig. 2 which is an example of a basic admittance-equalization network,
Fig. 3 which is an example of Smith chart used for determining the elements of the admittance-equalization network of Fig. 2,
Fig. 4a which is a diagram showing an example of responses of filters when they are connected to an interconnection network similar to the interconnection network described in Fig. 1 but in which the capacitor is absent,
Fig. 4b which is a diagram illustrating the effect of said capacitor,
Fig. 5 which synoptically shows an interconnection network according to a second embodiment of the present invention,
Fig. 6 which shows a diagram of the resulting reflection response of the filter bank which includes the interconnection network as described in Fig. 5,
Fig. 7 which synoptically shows a second embodiment of the filter bank according to the present invention,
Fig. 8 which synoptically shows a third embodiment of the filter bank FB3 according to the present invention,
Fig. 9 which synoptically shows a fourth embodiment of the filter bank FB4 according to the present invention,
Fig. 10 which synoptically shows a variant of one of embodiments of filter bank according to the present invention, and
Fig. 11 which depicts a transceiver TR according to the invention.

In the microwave domain of the present invention, different technologies may be applied: stripline, microstrip or coplanar technologies. Stripline lines are conductive lines that are embedded in a dielectric and/or magnetic substrate which has its back and top sides recovered by a ground plane. Microstrip lines are also conductive lines but they are deposited on the topside of a dielectric and/or magnetic substrate, only the backside of the substrate being recovered by a ground plane. In the coplanar technology, the ground plane surrounds the lines, sometimes with the backside of the substrate also recovered by a plane connected to the ground. Though the invention is mainly described in relation with the microstrip technology, it may be understood that it is not limited thereof and includes also any embodiment that is performed with stripline and coplanar technologies.

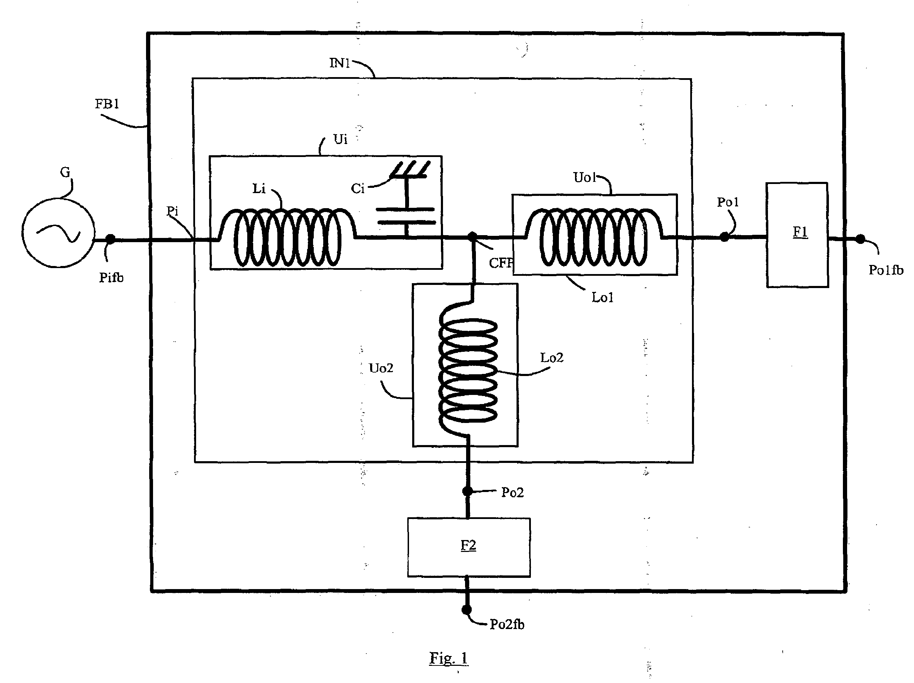

Fig. 1 synoptically shows a microwave filter bank FB1 according to a first embodiment of the present invention. The microwave filter bank FB1 comprises an input port Pifb, two output ports Po1tb and Po2fb, two bandpass filters F1 and F2 and an interconnection network IN1 which comprises a single input port Pi and two output ports Po1 and Po2.

Note that, in the following, the terminology "input" and "output" refers to the use of a filter bank as an energy splitter but does not mean that it cannot be used as an energy combiner, since both the interconnection network and filters according to the invention arc of the reciprocal type.

The input port Pi of the interconnection network IN 1 is connected to the input port Pifb and the outputs ports Po1 and Po2 are respectively connected to the inputs of filters F1 and F2. The outputs of Biters F1 and F2 are respectively connected to the output ports Po1fb and Po2fb.

Assuming in the example of the embodiment shown in Fig. 1 that the filter bank FB1 is used as an energy splitter, an electromagnetic energy signal supplier G is then upstream connected to the input port Pifb and the frequency band of the input signal is split in two sub-bands SB1 and SB2.

The interconnection network IN1 comprises an input unit Ui upstream connected to the input port Pi and two output units, respectively marked as to Uo1 and Uo2 in Fig. 1, upstream connected to the downstream port of the input unit Ui called in the following the central feeding point CFP, and respectively connected to the output ports Po1 and Po2.

The input unit Ui includes an inductor Li and a capacitor Ci which connects the central feeding point CFP to the ground. The output unit Uo1, respectively Uo2, includes an inductor Lo1, respectively Lo2. The inductor Li is connected to the input port Pi and to the central feeding point CFP. The upstream extremity of the inductance Lo1, respectively Lo2, is connected to the central feeding point CFP and the downstream extremity of the inductance Lo1, respectively Lo2, is connected to the output port Po1, respectively Po2, connected to the filter F1, respectively F2.

The combination of such input and output units Ui and Uo1, Uo2 avoids the power division effect which usually occurs in usual interconnection network because it forms an admittance-equalizing network. Moreover, such a combination permits to respect the shape factor of the constituent filters, with no additional energy-overlapping between adjacent sub-bands.. Another advantage of such a combination of units is about the insertion loss, resulting of the insertion of passive elements, which can be minimised by determining their values appropriately and which is uniformly distributed in the frequency band of the input signal independently of the number of filters connected to output ports of the filter bank FB1.

The values of inductors Li, Lo1 and Lo2 and capacitor Ci are determined in order to obtain an admittance-equalizing network according to a two-steps process according to the present invention. Such a two-steps process is based on the well-known matching method used in the radio-frequency domain to match, generally speaking, a load impedance $Z_T$ to the characteristic impedance $Z_0$ of a transmission line.

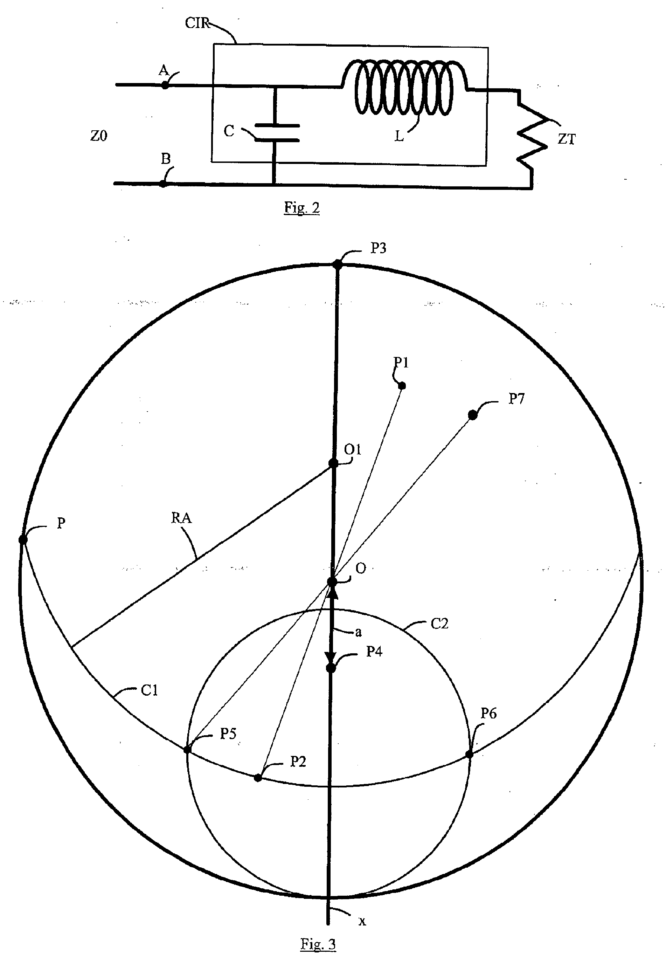

Before explaining the two-steps process according to the invention for optimising the values of inductors and capacitor, Fig. 2 and 3 provide an example which illustrates how the passive elements values of a basic admittance-equalization network CIR can be determined using a Smith chart in order that a load impedance $Z_T$ matches the characteristic impedance $Z_0$ when the admittance-equalization network and the load are viewed from a predetermined reference plane (A,B). The admittance-equalization network CIR is not identical to the admittance-equalizing network according to the present invention but is only provided for illustration purpose of the well-known matching method.

Fig. 2 represents a diagram of an example of the admittance-equalization network CIR. According to this example, the admittance-equalization network CIR comprises a capacitor C plugged in parallel at points A and B with a transmission line having a characteristic impedance $Z_0$ and an inductor $L$ plugged in series with the load the impedance of which is $Z_T$.

Note that in the following the reduced (or normalised) impedances or admittances will be considered. A reduced impedance z is equal to the impedance Z divided by the characteristic impedance $Z_0$.

Fig. 3 shows an example of a Smith chart used for determining the values of passive elements of the admittance-equalization network CIR.

Roughly speaking, the Smith chart is plotted on the complex reflection coefficient plane in two dimensions and is scaled in normalised impedance or admittance. The region at the right of the x-axis (real axis) represents impedances and admittances with positive imaginary part and the region at the left of the x-axis represents impedances and admittances with negative imagery parts. If the load impedance matches perfectly with the characteristic impedance, the reflection coefficient is zero, represented by a 'circle' of zero radius or in fact the point O at the centre of the Smith chart. If the load is a perfect open or short circuit the magnitude of the voltage reflection coefficient would be unity, all power would be reflected and the point P would lie on the unity circumference circle of the Smith chart. More precisely, for an open circuit, the complex reflection coefficient/$p$=1 and the reduced impedance $z_T$ = ∞, and for a short circuit, $p$ = -1 and $Z_T$ = 0.

The reduced load impedance $z_T = a + jb$ where $a$ is the real part of the reduced impedance $Z_T$ and b is the imaginary part may both be known or obtained from some measurement of the complex reflection coefficient

ρ by the equation $z_T = \dfrac{1+\rho}{1-\rho}$. The reduced impedance

$z_T$ is then plotted on the Smith chart at point P1 in this example. Next, the point P2 is plotted on the Smith chart symmetrically to the point P1 from the centre O. The point P2 represents the reduced admittance $y_T = \dfrac{1}{z_T}$. Next, a distance equals to the real part $a$ of the reduced impedance $z_T$ is plotted on the real x-axis from the centre O in order to obtain the points P4. A circle C1 is then drawn the centre O1 of which is in the middle of the segment [P3,P4] where the point P3 is the top extremity of the x-axis and the radius RA equal to the distance between the centre O1 and the point P2. Each point on the circle C1 is relative to an' admittance value $y_{AB}$ viewed from the reference plane (A,B). Considering now the two intersections of the circle C1 with the circle C2 relative to the admittances which are equal to 1, two points P5 and P6 are obtained. The points P5 and P6 are the two potential admittances $y_{AB}$ which can be used for matching the reduced impedance $z_T$ with the characteristic impedance $Z_0$ when the impedance-equalization network CIR and the load are viewed from the reference plane (A,B). According to the structure of the impedance-equalization network CIR, the admittance $y_{AB} = y+jC\omega Z_0$ with ω = 2πf and $y = g + jb.$ For obtaining the admittance matching at the frequency $f$, the real part $y$ of $y_{AB}$ shall be equal to 1 and its imaginary part equals to 0. Consequently, $b + C\omega Z_0 = 0$ and thus b <0. The admittance $y_{AB}$ which has a negative susceptance (at le left of the x-axis), i.e. the admittance relative to the point P5 shall thus be selected in this example. The real part g and the imaginary part $b$ relative to the point P5 are then read from the Smith chart and the capacitor value C is obtained by solv-

ing the equation $C = -\dfrac{b}{\omega Z_0}$ . The value of the inductor L is obtained from the reduced impedance $z_{AB}$ relative to the selected admittance $y_{AB}$. The reduced impedance $z_{AB}$ is linked with the inductor value L by the equation

$$z_{AB} = z_T + j\frac{L\omega}{Z_0}.$$ For that, the point P7 is plotted on the Smith chart, point which is the symmetrical point of the point P5 from the centre O. Next, the real and imaginary part of the impedance $z_{AB}$ are read on the Smith chart and the inductor value L is finally obtained by solving the equation $z_{AB} = z_T + j\dfrac{L\omega}{Z_0}.$

The first step of the two-steps process used for determining the values of inductors Li, Lo1 and Lo2 and capacitor Ci of the interconnection network IN1 shown in Fig. 1 consists in determining the optimal values of inductors Lo1 and Lo2 when the filters bank FB1 is viewed from the input port Pifb. The inductor Lo1, respectively Lo2 arc optimised in order to get a good in-band matching of the response of the filter F1 with a targeted response, respectively F2, i.e. in order that the operating sub-band of the filter F1, respectively F2, is centred on the central frequency of the operating sub-band of said targeted response and the width of the operating sub-band of the filter F1, respectively F2, is quite similar to the width of the operating sub-band of said targeted response, while obtaining a behaviour equivalent to an open-circuit for the frequencies adjacent to the operating band of the filter F1, respectively F2. In other words, the inductor value Lo1, respectively Lo2, is optimised in order to minimize the degradation of the targeted transmission and reflection response of the filter F1, respectively F2, when such filters are included in the filter bank FB1.

The values of inductors Lo1 and Lo2 are optimised separately following the above-explained matching method based on the Smith chart. Note that, the modification of the value of Lo1, respectively, Lo2, has not a significant effect on the matching of filter F2, respectively F1, at its central frequency.

Next, the second step of the two-steps process consists in determining the values of inductors Li and capacitor Ci in order to obtain an admittance-equalization for each operating band of the filter bank FB1 once the inductors values Lo1 and Lo2 have been optimised according to the first step. Obtaining an admittance-equalization means that a nearly constant total admittance value, viewed from the input port Pifb (said admittance value being adapted to the admittance of the energy signal supplier G), is obtained for the operating band of each filter, for example F1, of the filter bank FB1, while obtaining a behaviour of other filters, for example F2, which is equivalent to an open circuit for the operating band of the filter F1.

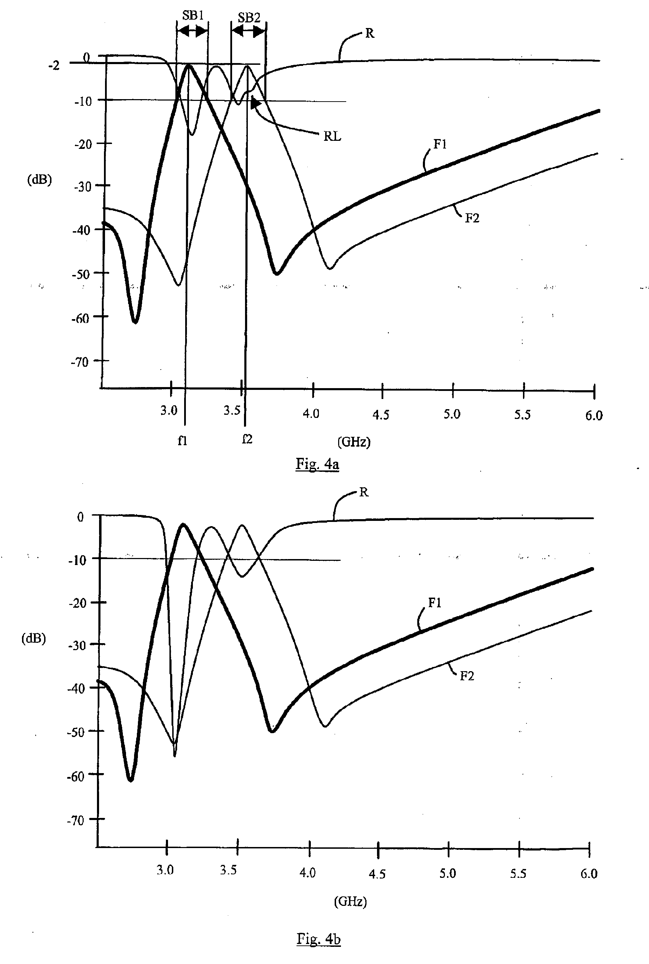

Fig. 4a shows an example of responses (amplitude vs. frequency) of filters F1 and F2 when they are connected to an interconnection network similar to the interconnection network IN1 but in which the capacitor Ci is absent. The reflection response R of the filter bank is also plotted in Fig. 4a.

According to this example, the central frequencies f1 and f2 of sub-bands SB1 and SB2 are respectively 3,165 GHz and 3,549 GHz. The sub-band SB1, respectively SB2, is related to the filter F1, respectively F2. Their widths are usually defined for an attenuation of 10 dB. When a filter is inserted in a filter bank, an insertion loss always occurs. Here its value is around 2 dB when the filter bank is fed by an electromagnetic energy input signal in the band 3,1-3,6 GHz.

The typical values of current planar integrated inductors are few nH. The values of inductors Li, Lo1 and Lo2 have been respectively fixed to 0,1 nH, 0,14 nH and 0,11 nH. The inventor has observed that for values equal to few nH the resulting response of the filter bank includes systematically in-band return loss.

As shown in Fig. 4a, the reflection response R in all the width of the sub-band SB1, which is called the in-band return loss in sub-band SB1, is under 10 dB. That means that the response of filter F1 is good in term of frequency performance because there is not any in-band return loss which is greater than 10 dB in the sub-band SB1. However, the response of filter F2 shall be improved because some in-band return loss (referred as RL in Fig. 2) occurs in the sub-band SB2 which degrades the frequency performance of filter F2.

In order to suppress (or at least minimize) such in-band return loss, the inventor has observed that decreasing the values of inductors and especially Li, improves the performance of the filter's response but such decreasing of inductor values is not usually sufficient for reducing significantly the in-band return loss in the sub-band because the needed values of inductors should be then lower than few nH, values can not be obtained in practice.

In order to suppress (or at least minimize) the in-band return loss in sub-bands and thus to increase the transmission performance of the filter bank, the present invention relaxes the constraints on the inductor values by introducing, in the interconnection network IN1, the capacitor Ci the function of which is to minimize the effect of the reflection response of the filter bank in its operating sub-bands without degrading its transmission response by shifting the phase of the equivalent admittance at the input of the interconnection network over its operating sub-bands.

In terms of frequency, the association of capacitor Ci with the inductor Li have the function of low pass filtering. Thus, the in-band loss return in the sub-band SB2 can be suppressed by filtering it using the low pass filter formed by the inductor Li and the capacitor Ci the values of which are determined for obtaining the adapted cut frequency in the sub-band SB2. The resulting responses of filters F1 and F2 when they are connected to the interconnection network IN1 are shown in Fig. 4b where the in-band return loss in the sub-band SB2 is now less than 10 dB. These resulting responses of filters F1 and F2 have been obtained for inductors and capacitor values which are easily obtained in practice. According to the previous example, the values of inductors Li, Lo1 and Lo2 are respectively equals to 1,8 nH, 2,5 nH and 1 nH and the value of capacitor Ci equals to 0,96 pF. Note that the in-band reflection levels are not balanced between the sub-bands SB1 and SB2.

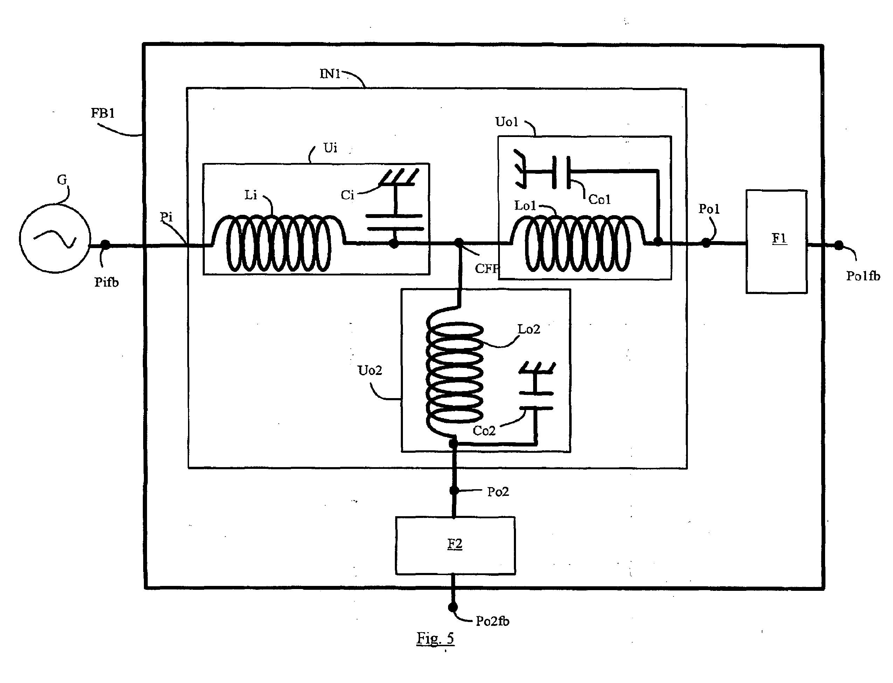

Fig. 5 synoptically shows an interconnection network 1N2 according to a second embodiment of the present invention. The elements of Fig. 5 which have the references of elements of Fig. 1 are the same elements.

According to this second embodiment, one capacitor is added per sub-band in order to balance the in-band reflection levels for the sub-bands SB1 and SB2. The output unit Uo1, respectively Uo2, thus includes now a capacitor Co1, respectively Co2. The capacitor Co1 connects the output port Po1 to the ground and the capacitor Co2 connects the output port Po2 to the ground.

As explained above, the values of capacitor Co1 and Co2 are determined using the method based on the Smith chart.

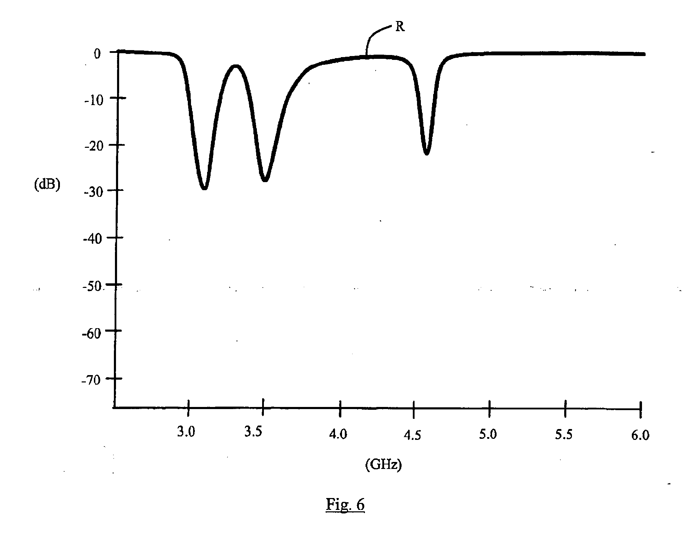

Fig. 6 shows a diagram of the resulting reflection response of the filter bank FB1 which includes the interconnection network as described in Fig. 5. The interconnection network IN2 performance is improved compared to the interconnection network IN1 performance because the in-band reflection levels are now balanced between the sub-bands SB1 and SB2.

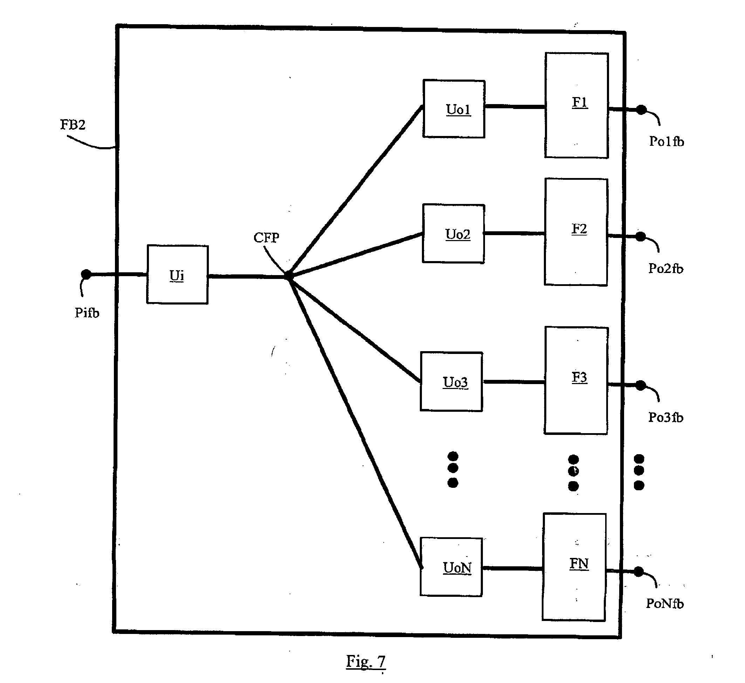

Fig. 7 synoptically shows a second embodiment of the filter bank FB2 according to the present invention. By considering the filter bank used as an energy splitter, the filter bank is intended to decompose the frequency band of the input energy signal in a plurality of sub-bands SB1,...,SBN.

The filter bank comprises an input unit Ui which is upstream connected to an input port Pifb of the filter bank FB2 and downstream connected to a central feeding point CFP. The filter bank FB2 comprises also a plurality of output unit Uo1,...,UoN, all upstream connected to the central feeding point CFP. The output unit Uo1, respectively Uo2,...,UoN, is downstream connected to the input of a filter F1, respectively F2,...,FN. The output of the filter F1 is connected to an output port Po1fb, respectively Po2fb,...,PoNfb, of the filter bank FB2.

Such an association of filters F1,..., FN and units Ui, Uo1,..., UoN is called In the following a parallel association of additional filters F3,...,FN.

The input unit Ui includes an inductor and a capacitor (not shown) as described in Fig. 1. The output unit Uo1,..,UoN includes each an inductor (not shown) as described in Fig. 1 but according to a variant each of them may include a capacitor as described in Fig. 5.

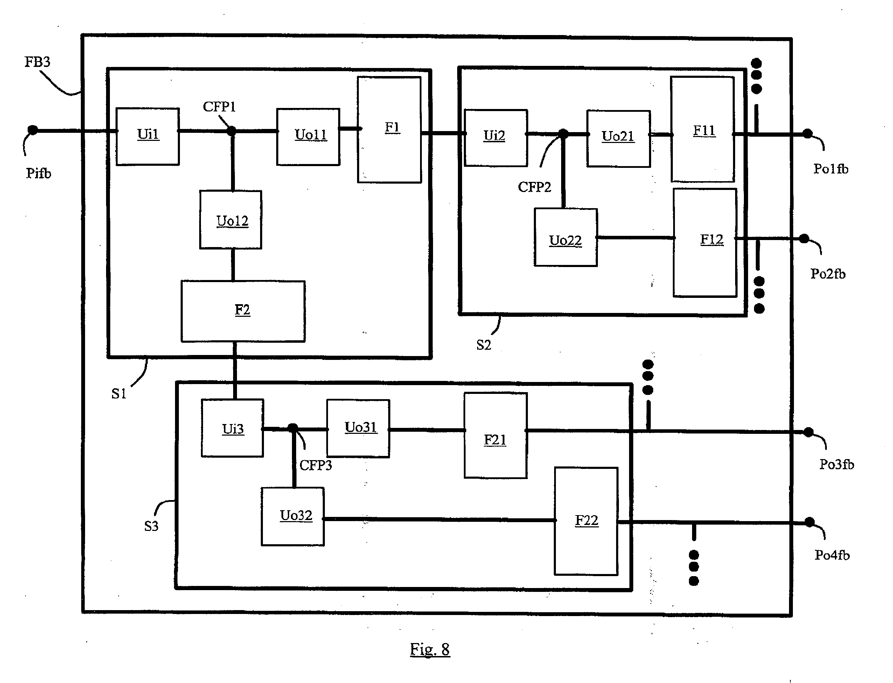

Fig. 8 synoptically shows a third embodiment of the filter bank FB3 according to the present invention.

By considering the filter bank as an energy splitter, the filter bank FB3 is intended to decompose the frequency band of an input energy signal in a first and a second sub-bands SB1 and SB2 (first level of the frequency decomposition), and to decompose each of sub-bands SB1 and SB2 in two sub-bands respectively SB11, SB12 and SB21, SB22 (second frequency decomposition). Such a frequency decomposition of the frequency band of the input signal is just an example of embodiment of a filter bank FB3 according to the present invention which can be applied more generally for decomposing recursively each sub-band obtained at a given level by two sub-bands at the next level.

The filter bank FB3 comprises a first structure S 1 identical to the structure of the interconnection network IN1 shown in Fig. 1 or Fig. 5. The structure S1 includes an input unit Ui1 which is downstream connected to the central feeding point CFP1 and upstream connected to the input port Pifb of the filter bank FB3. The structure S 1 includes also an output unit Uo1 1 which is upstream connected to the central feeding point CFP 1 and downstream connected to a filter F1. The structure S 1 includes finally an output unit Uo12 which is upstream connected to the central feeding point CFP1 and downstream connected to a filter F2.

The filter bank FB3 comprises a second structure S2 identical to the structure of the interconnection network IN1 shown in Fig. 1 or Fig. 5. The structure S2 includes an input unit Ui2 which is downstream connected to a central feeding point CFP2 and upstream connected to the output of the filter F1. The structure S2 includes also an output unit Uo21 which is upstream connected to the central feeding point CFP2 and downstream connected to a filter F11. The output of the filter F11 is connected to an output Po1fb of the filter bank FB3 from which an output signal related to the sub-band Sb11 is obtained. The structure S2 includes finally an output unit Uo22 which is upstream connected to the central feeding point CFP2 and downstream connected to a filter F12. The output of the filter F12 is connected to an output Po2fb of the filter bank FB3 from which an output signal related to the sub-band Sb12 is obtained.

The filter bank FB3 comprises finally a third structure S3 identical to the structure of the interconnection network IN1 shown in Fig. 1 or Fig. 5. The structure S3 includes an input unit Ui3 which is downstream connected to a central feeding point CFP3 and upstream connected to the output of the filter F2. The structure S3 includes also an output unit Uo31 which is upstream connected to the central feeding point CFP3 and downstream connected to a filter F21. The output of the filter F21 is connected to an output Po3fb of the tilter bank FB3 from which an output signal related to the sub-band Sb21 is obtained. The structure S3 includes finally an output unit Uo32 which is upstream connected to the central feeding point CFP3 and downstream connected to a filter F22. The output of the filter F22 is connected to an output Po4fb of the filter bank FB3 from which an output signal related to the sub-band Sb22 is obtained.

The input units Ui1, Ui2, Ui3 include each an inductor and a capacitor (not shown) as described in Fig. 1. The output unit Uo11, Uo12, Uo21, Uo22, Uo31 and Uo32 includes each an inductor (not shown) as described in Fig. 1 but according to a variant each of them includes a capacitor as described in Fig. 5.

Such an association of the three structures S1, S2 and S3 is called in the following a parallel-series association of additional filters F11, F12, F21 and F22.

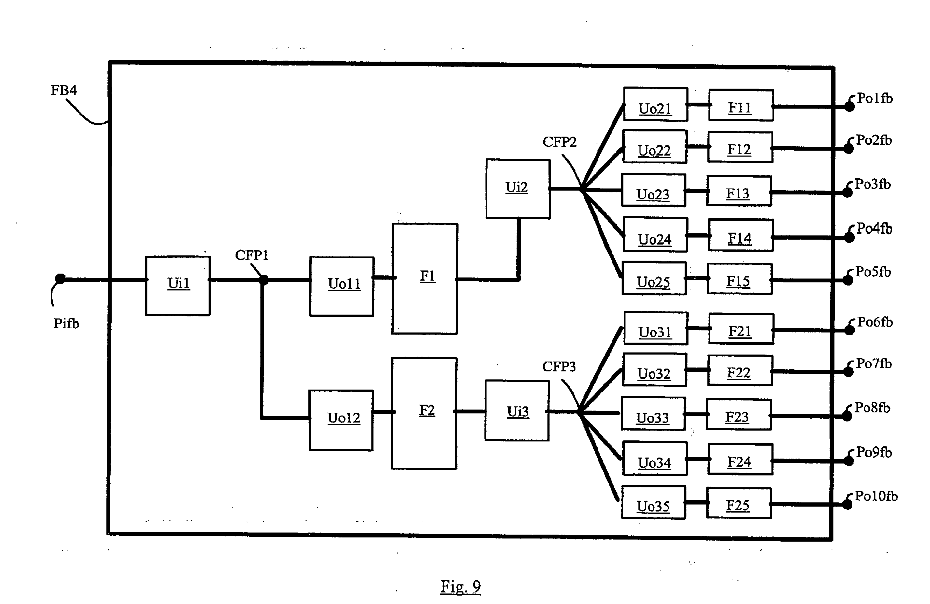

Fig. 9 synoptically shows a fourth embodiment of the filter bank FB4 according to the present invention. By considering the filter bank as an energy splitter, the filter bank FB4 is intended to decompose the frequency band of the input energy signal into two sub-bands, and to decompose each of them in five sub-bands SB11,..., SB15 and SB21,...,SB25. The structure of the filter bank FB4 is obtained by combining the parallel association (Fig. 7) and parallel-series association (Fig. 8) of additional filters.

Such a decomposition of the frequency band of the input signal is just an example of embodiment of a filter bank FB4 according to the present invention which can be applied more generally by combining alternatively (or not) the parallel association of Fig. 7 and/or parallel-series association of Fig. 8 of additional filters.

The embodiment of filters described above in Figs. 1 to 9 comprises passive elements (inductors and capacitors). Such components provide to the filter banks an easier miniaturisation on semiconductor substrate. For such a miniature integration of inductors and capacitors, planar spiral inductor ("Accurate modelling of high-Q spiral inductors in thin-film multiplaycr technology for wireless telecommunication applications", P. Pieters et al., IEEE transactions on microwave theory and techniques, vol. 49, n° 4, April 2001), ferromagnetic rectangular inductor (« Sandwitch-Type Ferromagnetic RF integrated inductor », M. Yamaguchi et al., IEEE transactions on microwave theory and techniques, vol. 49, Dec. 2001), metal-insulator-metal capacitor ("Impact of Design on high frequency performances of advanced MIM capacitors using SiN dielectric layers", J. Piquet et al., IEEE transactions on microwave theory and techniques, June. 2005) are some examples of suitable technologies. A three dimensional miniature integration of inductors and capacitors may also be based, for example on Low Temperature Co-fircd Ceramic technology (LTCC technology).

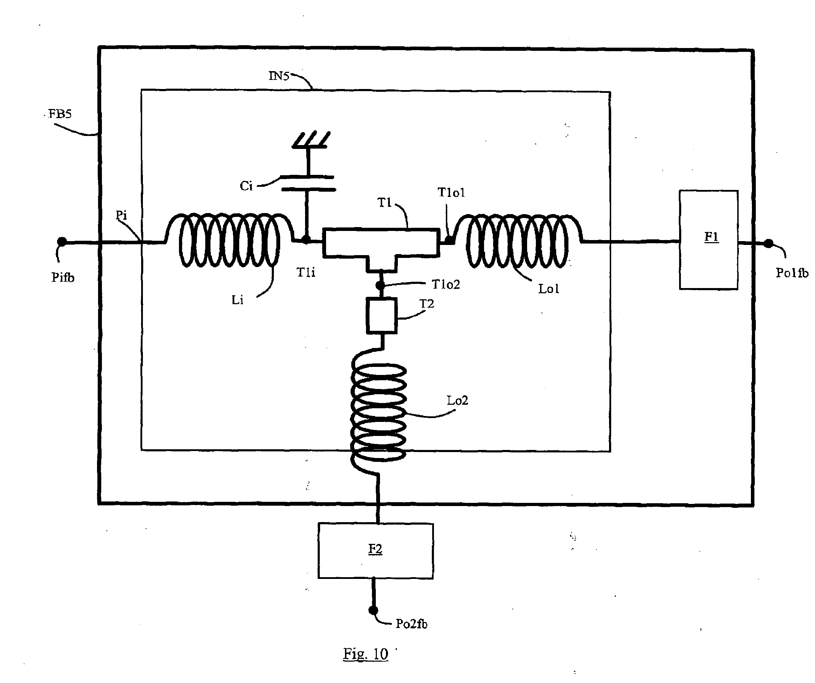

Fig. 10 synoptically shows a variant of one of embodiments of filter bank according to the present invention.

This variant is sometimes required for the practical realization of a filter banks according to the invention. This variant is described in relation with the filter bank FB1 described in Fig. 1 for connecting the elements to the central feeding-point CFP of the interconnection network IN1 but can be used for connecting any other passive elements of other interconnection networks included in other filter banks according to the invention.

According to this variant, two transmission lines T1 and T2 connect the inductors Li, Lo1 and Lo2. The transmission line T1 is a tee junction which comprises an input port Tli and two output ports T1o1 and T1o2. The transmission line T2 has the shape of a rectangular. The input port T1i is connected to the downstream port of the inductor Li, the output port T1o1 is connected to the upstream port of the inductor Lo1 and the output port T1o2 is connected to the input port of the transmission line T2. The output port of the transmission line T2 is connected to the upstream port of the inductor Luo2.

This variant does not modify the function of passive elements of the interconnection network IN1 as described above but their values should be determined from the method based on the Smith Chart by taking into account the inductive and capacitive effect of the included transmission lines.

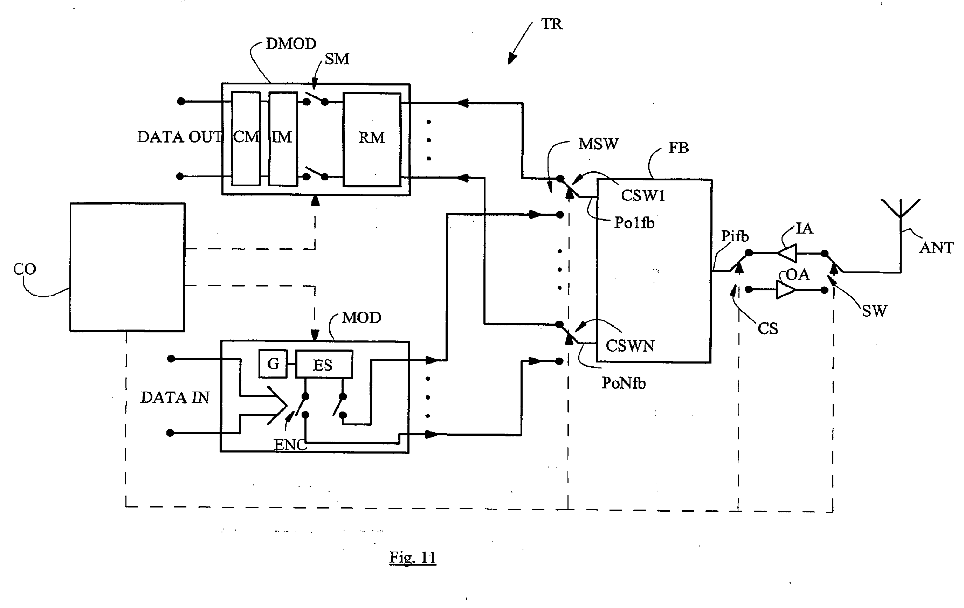

Fig. 11 depicts a transceiver TR according to the invention. It comprises a filter bank FB acting either as a multiplexer or as de-multiplexer depending on the propagation direction of the signals (it will be said, for purposes of simplicity, muhiplexer), said filter bank FB being in accordance with one of the embodiments represented in one of the Figs. 1, 5, 7, 8, 9 or 10 with one embodiment derived from one of these embodiments. The multiplexer FB has a first port Pifb which is connected to the common contact of a controlled switch CS, the two other contacts thereof being respectively connected to the output of an amplifier IA and the input of another amplifier OA. The input of the amplifier IA is connected to a contact of another switch SW whereas the output of the amplifier OA is connected to another contact of the switch SW. The common contact of the switch SW is connected to an antenna ANT.

Each other port Pojfb (j = 1 to N) of the multiplexer FB is connected to the common contact of a controlled switch CSWj amongst all the switches of a multiswitch MSW, the two other contacts being respectively connected to an output port of a multiport of a modulator MOD and to an input port of a multiport of a demodulator DMOD.

The modulator MOD includes a pulse generator G producing a basic pulse sequence having a uniform frequency spectrum in a frequency band of the transceiver TR, this pulse generator G delivered to an energy splitter ES despatching on respective outputs the energy of the pulse contained in a plurality of sub-bands of said frequency band. The energy splitter is formed by a filter bank in accordance with one of the embodiments represented in one of the Figs. 1, 5, 7, 8, 9 or 10, or with one embodiment derived from one of these embodiments. Each output of said energy splitter is connected to one of the switches of an encoder ENC controlled by each bit of the input data and delivering in the corresponding frequency sub-band a modulated pulse sequence. All the outputs of the encoder ENC form the output multiport of the modulator MOD.

The modulator MOD is thus provided for modulating input data with a predetermined number of frequency pulses in rcspcctivc sub-bands.

The demodulator DMOD includes recovery means RM intended to recover the energy delivered over each input ports of the multiport thereof, synchronisation means SM constituted by a plurality of controlled switches, integrating means IM and comparator means CM intended to compare the signals delivered by said integrating means IM with predetermined threshold values and to deliver the output data under the form of a plurality of bits. The synchronisation means SM and the integrating means IM are intended to deliver over each input of the comparator means CM a signal representative of the power carried in each sub-band during the channel delay.

The demodulator DMOD is thus provided for demodulating signals received in said sub-bands in order to recover the transmitted data.

A controller CO is provided in order to control the switches CS and SW, the multiswitch MSW and the modulator-MOD and the demodulator DMO as well. When the transceiver TR is intended to transmit data, the multiswitch MSW is in a position in which the modulator MOD is connected to the filter bank FB, acting then as a multiplexer, the switch CS is in a position in which the filter bank FB is connected to the amplifier OA and the switch SW is in a position in which the amplifier OA feeds the antenna ANT. When the transceiver TR is intended to receive data, the switch SW is in a position in which the antenna ANT fccds the amplifier IA, the switch CS is in a position in which the amplifier IA is connected to the filter bank FB, acting then as a de-multiplexer, and the multiswitch MSW is in a position in which the filter bank FB is connected to the demodulator DMOD.

The filter bank FB is thus intended either to receive and to merge all the frequency pulses generated by the modulator MOD in said respective sub-bands in order to transmit them by means of the amplifier OA and the antenna ANT or to receive and to split signals received in said sub-bands by means of the antenna ANT and the amplifier IA in order to deliver them to said demodulator DMOD.

The embodiments of the present invention described above have been given only for illustration purpose but the scope of the invention is not limited to these embodiments.

## Claims

1. Microwave filter bank intended to be used either as or a multiplexer or de-multiplexer in a UWB-typc system, said microwave filter bank including a plurality of filters and an interconnection network both connecting a first port (Pifb) of said microwave filter bank to other ports of said microwave filter bank, **characterised in that** said interconnection network includes a plurality of inductors, one of said inductors (Li), said first, has one of its extremities directly connected to said first port (Pifb) and its second extremity connected to the ground through a capacitor (Ci), said. first, intended to minimize the effect of the reflection response of the microwave filter bank in its operating sub-bands without degrading its transmission response, said first inductor (Li) and capacitor (Ci) being intended to provide a nearly constant total admittance at said first port of said microwave filter bank for the operating band of each of said filters, each of other inductors, said second, is intended to provide a good in-band matching of the response of one of said filters with a targeted response.

2. Microwave filter bank as claimed in claim 1, **characterised in that** an extremity of each of said second inductors is connected to the ground through a capacitor intended to balance the in-band reflection levels over the frequency response of said filters.

3. Microwave filter bank as claimed in claim 1 or 2, **characterised in that** an extremity of each inductor is connected to a common point, said central feeding point (CFP), of the interconnection network, said central feeding point (CFP) being connected to the ground through said first capacitor (Ci).

4. Microwave filter bank as claimed in claim 3, **characterised in that** said extremity of each inductor is connected to said central feeding point (CFP) through at least one transmission line (T1,T2).

5. Microwave filter bank as claimed in one of claims 1 or 4, **characterised in that** each of said filters is connected to a single port of said microwave filter bank and to a single of said second inductors.

6. Microwave filter bank as claimed in one of claim 4, **characterised in that** said interconnection network includes at least one other of said first inductor (Ui) connected each to a different central feeding point (CFP2, CFP3), at each of said central feeding point (CFP2, CFP3) at least two of said second inductors are connected.

7. Transceiver intended to be used in a UWB-type system, **characterised in that** it includes at least one microwave filter bank as claimed in one of claims 1 to 6 intended to be used either as an energy splitter of an electromagnetic energy signal or an energy combiner of multiple electromagnetic energy signals.

Fig. 1

Fig. 2

Fig. 3

Fig. 4a

Fig. 4b

Fig. 5

Fig. 6

Fig. 7

Fig. 8

Fig. 9

Fig. 10

Fig. 11

EP 1 950 828 A1

**European Patent Office**

## EUROPEAN SEARCH REPORT

Application Number

EP 07 00 1610

### DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | WO 01/56044 A (KONINKL PHILIPS ELECTRONICS NV [NL]; HORIE KENICHI [NL]) 2 August 2001 (2001-08-02) * page 9, line 21 - page 19, line 19; figure 4 * ----- | 1-7 | INV. H01P1/213 H03H7/46 |
| X | US 2002/135438 A1 (MIYAMOTO KEIZO [JP] ET AL) 26 September 2002 (2002-09-26) * paragraph [0052] - paragraph [0055]; figure 20 * ----- | 1-7 | |
| A | GEORGE L. MATTHAEI ET AL: "Microwave Filters, impedance-matching networks, and coupling structures" 1980, ARTECH HOUSE BOOKS , NORWOOD, MA , XP002439647 * pages 1-3 * * pages 120-121 * * page 421 * * pages 481,484 * * pages 965,966 * ----- | 1-7 | |

TECHNICAL FIELDS SEARCHED (IPC)

H01P
H03H

The present search report has been drawn up for all claims

| Place of search | Date of completion of the search | Examiner |
|---|---|---|
| Munich | 28 June 2007 | LA CASTA MUNOA, S |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

&  : member of the same patent family, corresponding document

EPO FORM 1503 03.82 (P04C01)

**EP 1 950 828 A1**

## ANNEX TO THE EUROPEAN SEARCH REPORT
## ON EUROPEAN PATENT APPLICATION NO.

EP 07 00 1610

This annex lists the patent family members relating to the patent documents cited in the above-mentioned European search report.
The members are as contained in the European Patent Office EDP file on
The European Patent Office is in no way liable for these particulars which are merely given for the purpose of information.

28-06-2007

| Patent document cited in search report | | Publication date | Patent family member(s) | | Publication date |
|---|---|---|---|---|---|
| WO 0156044 | A | 02-08-2001 | EP 1166296 A1<br>JP 2001210527 A<br>US 2002153987 A1 | | 02-01-2002<br>03-08-2001<br>24-10-2002 |
| US 2002135438 | A1 | 26-09-2002 | JP 2002353775 A | | 06-12-2002 |

For more details about this annex : see Official Journal of the European Patent Office, No. 12/82

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- US 20040113716 A

- US 4367445 A

### Non-patent literature cited in the description

- **MASASHI NAKATSUGAWA.** A novel configuration for 1/N multiport power dividers using series/parallel transmission line division and a polyimidelalumina ceramic structure for HPA module implementation. *IEEE transactions on microwave theory and techniques,* June 2001, vol. 49 (6

- **P. PIETERS et al.** Accurate modelling of high-Q spiral inductors in thin-film multiplaycr technology for wireless telecommunication applications. *IEEE transactions on microwave theory and techniques,* April 2001, vol. 49 (4

- **M. YAMAGUCHI et al.** Sandwitch-Type Ferromagnetic RF integrated inductor. *IEEE transactions on microwave theory and techniques,* December 2001, vol. 49

- **J. PIQUET et al.** Impact of Design on high frequency performances of advanced MIM capacitors using SiN dielectric layers. *IEEE transactions on microwave theory and techniques,* June 2005